# FASCICULE DE BREVET EUROPEEN

(11) **EP 0 423 663 B1**
(45) Date de publication et mention de la délivrance du brevet: **07.09.1994**
(21) Numéro de dépôt: 90119677.4
(22) Date de dépôt: 15.10.1990
(51) Int. Cl.: G04G 7/00, H03L 7/14

(54) **Horloge synchronisée**
Synchronisierte Uhr
Synchronised watch

(30) Priorité: 17.10.1989 FR 8913551
(43) Date de publication de la demande: 24.04.1991
(73) Titulaire: ALCATEL CIT, 75008 Paris (FR)
(72) Inventeur: Lalanne, Alain, F-92700 Colombes (FR); Lankar, André, F-75010 Paris (FR)
(74) Mandataire: Weinmiller, Jürgen

(56) Documents cités:
- EP-A- 0 262 481
- EP-A- 0 326 899

## Description

La présente invention concerne une horloge d'une très grande stabilité synchronisée sur un signal sélectionné parmi plusieurs signaux de synchronisation externe.

Dans un autocommutateur numérique, on utilise classiquement une base de temps centrale dont les signaux sont distribués à différents organes, ce qui leur permet d'opérer en synchronisme.
Une base de temps triple d'un tel type est décrite notamment dans le brevet européen 0129 098. Les bases de temps de ce type sont commandées par le signal d'horloge fourni par une horloge synchronisée. Une telle horloge synchronisée reçoit plusieurs signaux de rythmes récupérés chacun sur une voie de communication telle qu'une liaison MIC. Elle s'asservit au moyen d'une boucle à verrouillage de phase numérique sur l'un de ces signaux de rythme qu'elle a sélectionné. La chaîne d'asservissement comprend, dans la boucle, un filtre numérique passe-bas à grande constante de temps, de l'ordre de plusieurs heures, de manière à éliminer la gigue que pourrait présenter le signal de rythme sélectionné.

En effet, la gigue est une perturbation de la fréquence dont la valeur moyenne sur une période correspondant sensiblement à la constante de temps de ce filtre est nulle. L'horloge synchronisée, après avoir sélectionné un signal de rythme, ne fournit un signal d'une grande précision qu'avec un retard correspondant approximativement à cette constante de temps.

Ainsi, lorsque l'horloge change de signal de rythme comme référence d'asservissement, il se produit généralement un saut de fréquence, soit qu'on laisse dériver l'horloge pendant le temps nécessaire à la synchronisation sur le nouveau signal de rythme équivalent à la constante de temps du filtre, soit qu'on raccourcisse temporairement la constante de temps du filtre mais, dans ce cas, on transmet la gigue de ce signal à l'horloge.

De plus, lorsque le signal de rythme sur lequel l'horloge est asservie vient à défaillir, se pose le problème de la sélection du nouveau signal de rythme qui doit servir de référence d'asservissement.

La présente invention a ainsi pour objet une horloge synchronisée sur plusieurs signaux de synchronisation qui résout les deux problèmes sus mentionnés.

L'horloge synchronisée selon l'invention reçoit plusieurs signaux de synchronisation externe qui sont soit un signal de référence soit des signaux de rythme et comprend
- un générateur d'horloge recevant un signal de commande et produisant un signal d'horloge,
- un dispositif d'asservissement recevant un desdits signaux de synchronisation externe et ce signal d'horloge qui élabore une commande d'asservissement,
- et est caractérisée en ce qu'elle comprend
- des moyens pour élaborer une commande d'asservissement additionnelle au moins associée à un autre des signaux de synchronisation externe,
- une unité de commande produisant ce signal de commande à partir d'une commande d'asservissement sélectionnée, et déterminant la commande d'asservissement sélectionnée en fonction des critères de qualité des signaux de synchronisation externe.

D'une part, l'horloge synchronisée comprend des moyens pour comparer une des commandes d'asservissement à un gabarit spécifiant des valeurs extrêmales et des variations temporelles maximales afin de produire une information d'aspect de cette commande d'asservissement, cette information d'aspect étant un de ces critères de qualité.

D'autre part, l'horloge synchronisée comprend des circuits de test de présence de rythme recevant chacun un signal de synchronisation externe et délivrant un signal de présence rythme si le signal reçu est présent, l'existence de ce signal de présence rythme étant un de ces critères de qualité.

De plus, l'horloge synchronisée reçoit des signaux de validation associés chacun à un des signaux de rythme signifiant un défaut sur ce signal de rythme, et élabore une information de validation associée à un de ces signaux de validation si celui-ci présente une durée inférieure à un seuil de durée et une fréquence d'apparition inférieure à un seuil de fréquence, la présence de cette information de validation étant un de ces critères de qualité.

En outre, dans l'horloge synchronisée l'unité de commande comprend une liste associant un rang de priorité à chacun des signaux de synchronisation externe, et la commande d'asservissement sélectionnée est la commande d'asservissement correspondant au premier signal de synchronisation externe de cette liste répondant à au moins un de ces critères de qualité..

Avantageusement, dans l'horloge synchronisée l'unité de commande a en mémoire une valeur de consigne, et sélectionne cette valeur de consigne comme la commande d'asservissement sélectionnée si aucun desdits signaux de synchronisation externe ne répond à au moins un de ces critères de qualité.

Dans un mode de réalisation, l'horloge synchronisée comprend un circuit d'analyse recevant un signal de calibration, le signal d'horloge et produisant une commande de calibration, et l'unité de commande comprend des moyens pour calculer la valeur de consigne à partir de cette commande de calibration.

De plus, l'horloge synchronisée comprend au moins un circuit d'analyse recevant un signal de contrôle, le signal d'horloge et produisant un signal de vérification et l'unité de commande produit une alarme si le signal de vérification n'est pas inscrit dans un gabarit spécifiant des valeurs extrêmales et des variations temporelles maximales.

De même, l'horloge synchronisée produit une alarme si un desdits signaux de rythme ne répond pas à au moins un des critères de qualité.

De plus, l'horloge synchronisée produit une alarme si le signal de référence ne répond pas à au moins un des critères de qualité.

En outre, l'horloge synchronisée produit une alarme de fonctionnement si un au moins des signaux de contrôle n'est pas inscrit dans un gabarit spécifiant des valeurs extrêmales et des variations temporelles maximales et si aucun des signaux de synchronisation externe ne répond à un au moins des critères de qualité.

Enfin, l'horloge synchronisée se caractérise en ce que les fréquences des signaux de rythme et/ou du signal de référence et/ou des signaux de contrôle et/ou du signal de calibration sont des multiples de la fréquence du signal d'horloge.

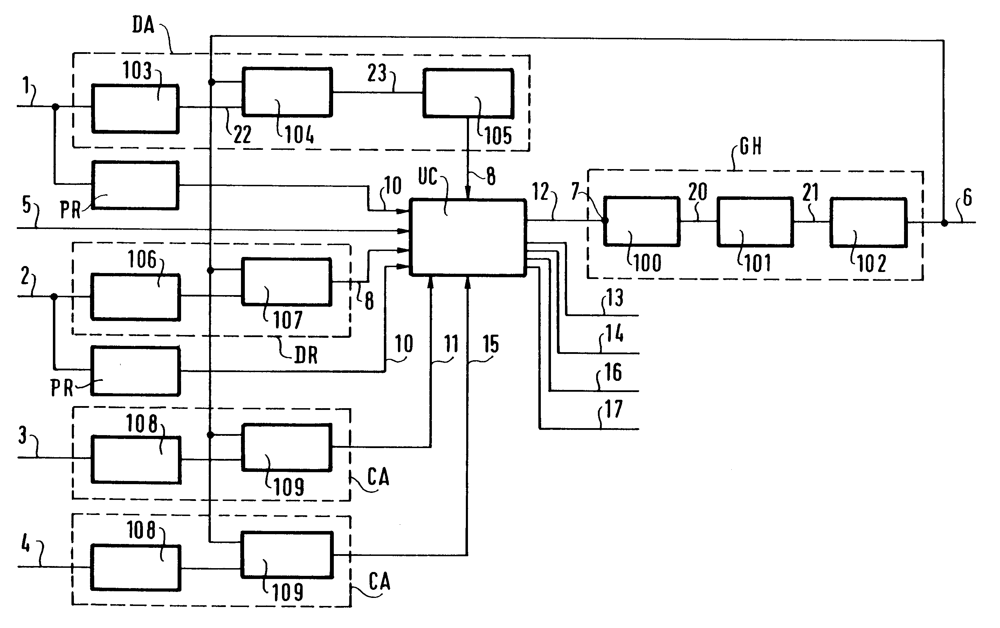

Les différents objets et caractéristiques de l'invention apparaîtront maintenant de manière plus détaillée dans la description d'un exemple de réalisation, donné à titre non limitatif, en se référant à la figure annexée qui représente un diagramme par blocs d'une horloge synchronisée selon l'invention.

L'horloge synchronisée telle que représentée à la figure reçoit plusieurs signaux de synchronisation externe qui sont soit des signaux de rythme 1 récupérés sur des voies de communication (ils sont au nombre de quatre, par exemple, bien qu'un seul apparaisse dans la figure), soit un signal de référence 2. Elle reçoit également des signaux de contrôle 3 (un seul est figuré) et un signal de calibration 4.

Elle reçoit enfin des signaux de validation 5 (un seul est figuré) qui sont associés à chacun des signaux de rythme 1. Elle produit un signal d'horloge 6.

L'horloge synchronisée comprend :
- un générateur d'horloge GH pourvu d'une entrée de commande 7 qui fournit le signal d'horloge 6,
- des dispositifs d'asservissement DA, en nombre égal à celui des signaux de rythme 1 recevant chacun un de ces signaux et le signal d'horloge pour produire une commande d'asservissement 8,
- un dispositif de régulation DR recevant le signal de référence 2 et le signal d'horloge produisant aussi une commande d'asservissement 8,
- des circuits de test de présence de rythme PR recevant chacun un signal de synchronisation externe et produisant un signal de présence rythme 10,
- des circuits d'analyse CA recevant d'une part soit un signal de contrôle 3, soit le signal de calibration 4 et, d'autre part, le signal d'horloge 6, pour produire respectivement des signaux de vérification 11 et une commande de calibration 15,
- une unité de commande UC recevant les commandes d'asservissement 8, les signaux de validation 5 les signaux de présence rythme 10, les signaux de vérification 11, la commande de calibration 15, pour produire un signal de commande 12 appliqué sur l'entrée de commande 7 et des signaux d'alarme 13, 14, 16, 17.

Le générateur d'horloge GH comprend un circuit de conversion 100 qui transforme le signal de commande numérique 12 en un signal d'asservissement 20 analogique dont la valeur est proportionnelle à ce signal de commande. Il comprend également un générateur de fréquence 101 tel qu'un oscillateur à quartz commandé en tension de très grande stabilité, qui reçoit comme tension de commande le signal d'asservissement 20 et qui produit un signal pilote 21.

Ce signal pilote, à 10 MHZ par exemple, est ensuite traité dans un diviseur de fréquence 102 qui produit le signal d'horloge 6 à 8 KHZ par exemple.

Un dispositif d'asservissement DA comprend un diviseur de fréquence 103 qui reçoit un signal de rythme 1 et produit un signal de rythme intermédiaire 22 à la même fréquence que celle du signal d'horloge 6. Avantageusement le signal de rythme aura une fréquence multiple de celle du signal d'horloge, 2,048 MHZ par exemple;
Le diviseur de fréquence 103 pourra ainsi consister en un simple compteur. Le dispositif d'asservissement DA comprend également une boucle à verrouillage de phase 104 numérique qui reçoit le signal de rythme intermédiaire 22 et le signal d'horloge 6 et qui produit un signal de phase 23 propre à asservir le générateur d'horloge. Ce signal de phase est injecté sur un filtre numérique passe-bas 105 à très forte constante de temps, plusieurs heures par exemple.
Ce filtre produit une commande d'asservissement 8 débarrassée de la gigue du signal de rythme 1.

Un dispositif de régulation DR a la même fonction qu'un dispositif d'asservissement DA. Il reçoit un signal de référence 2, tel que celui produit par une horloge atomique, qui ne présente pas de gigue; le filtrage numérique évoqué ci-dessus n'est donc pas nécessaire. Il comprend un diviseur de fréquence 106 qui ramène la fréquence du signal de référence 2 à celle du signal d'horloge suivi d'une boucle à verrouillage de phase 107 numérique qui produit directement une commande d'asservissement 8.

Un circuit de test de présence de rythme PR délivre un signal de présence rythme 10 si le signal appliqué sur son entrée est présent. Il s'agira, par exemple, d'un circuit monostable dont la période caractéristique est légèrement supérieure à la période du signal appliqué sur son entrée.

Un circuit d'analyse CA délivre un signal de vérification 11 ou une commande de calibration 15 qui donne une information sur l'écart de phase entre un signal d'entrée et le signal d'horloge 6, information similaire à une commande d'asservissement. Ce signal d'entrée, un signal de contrôle 3, dans un premier cas, peut être le signal de sortie d'un des modules de la base de temps triple (celle évoquée dans le préambule, par exemple) commandée par le signal d'horloge 6 de la présente horloge synchronisée ou le signal d'horloge d'une deuxième horloge synchronisée, du même type. Dans un deuxième cas, le signal d'entrée est un signal de calibration 4 d'une très grande précision appliqué de manière temporaire. Ce circuit d'analyse CA comprend un diviseur de fréquence 108 qui ramène la fréquence du signal d'entrée à celle du signal d'horloge 6 suivi d'une boucle à verrouillage de phase 109 numérique qui produit un signal de vérification ou une commande de calibration.

L'unité de commande UC qui sera avantageusement composée d'un microprocesseur et d'une mémoire associée comprend des moyens pour effectuer les opérations suivantes :
- commande du générateur d'horloge,
- analyse des signaux de contrôle,
- analyse du signal de calibration,
- production d'alarmes.

L'unité de commande UC délivre le signal de commande 12 sélectionné parmi les commandes d'asservissement 8 au moyen de critères de qualité. Elle reçoit des signaux de validation 5 associés chacun à un signal de rythme 1, normalement à zéro qui passent à un lorsqu'un (des) défaut (s) est (sont) présents (s) sur ce signal de rythme. L'unité de commande élabore une information de validation si ce signal de validation 5 présente une durée inférieure à un seuil de durée et une fréquence d'apparition inférieure à un seuil de fréquence; ces deux seuils sont des valeurs numériques qui ont été introduites en mémoire. Elle élabore également une information d'aspect associée à une commande d'asservissement si celle-ci reste dans un gabarit préalablement inscrit en mémoire qui spécifie des valeurs extrêmales et des variations temporelles maximales.

Selon les cas, l'horloge synchronisée aura ou n'aura pas accès à un signal de référence 2. L'unité de commande UC comprend une liste où sont rangés par ordre de priorité les différents signaux de synchronisation externe, le signal de référence 2 étant le premier de cette liste s'il est présent.

L'unité de commande UC sélectionne comme signal de commande 12 la commande d'asservissement 8 issue du signal de référence 2 si le signal de présence rythme (premier critère de qualité) et l'information d'aspect (deuxième critère de qualité) qui lui sont associés sont présents. Si tel n'est pas le cas elle sélectionne la commande d'asservissement 8 correspondant au premier signal de rythme 1 pour lequel le signal de présence rythme (premier critère de qualité), l'information d'aspect ( deuxième critère de qualité) et l'information de validation (troisième critère de qualité) sont présents.

Si aucun des signaux de synchronisation externe ne satisfait aux critères de qualité mentionnés ci-dessus, l'unité de commande UC sélectionne comme signal de commande 12 une valeur de consigne enregistrée en mémoire. Cette valeur de consigne pourra résulter de la commande de calibration 15 générée par le signal de calibration 4, comme ce sera explicité ultérieurement.

L'horloge synchronisée comprend ainsi plusieurs boucles à verrouillage de phase numérique, la plupart de celles-ci étant des boucles ouvertes.

L'unité de commande UC ferme l'une de ces boucles de manière à appliquer le signal de commande 12. Elle comprend des moyens pour produire ce signal de commande 12 sans discontinuité de fréquence même lors d'une commutation de commande d'asservissement 8, car elle conserve en mémoire ces commandes d'asservissement et la fonction de transfert de la boucle.

A la suite d'un défaut sur un signal de synchronisation externe, l'unité de commande abandonne ce signal comme source d'asservissement et émet une alarme de défaut signal de rythme 13 ou de défaut signal de référence 14 (Une seule alarme 13 est représentée alors qu'il y en a une associée à chaque signal de rythme 1). Elle le récupère lorsque le défaut a disparu, après une temporisation éventuelle, de manière à prendre en compte le signal de synchronisation externe doté de la plus forte priorité.

L'unité de commande UC reçoit des signaux de vérification 11 associés à chacun des signaux de contrôle 3. Elle produit des alarmes de défaut signal de contrôle 16 (une seule est représentée) si l'un de ces signaux ne répond à des spécifications similaires à celles qui ont été décrites pour les signaux de synchronisation externe; valeurs extrêmales, variations temporelles maximales etc...

L'unité de commande UC peut recevoir une commande de calibration 15. En effet, si l'horloge synchronisée n'a pas accès à un signal de référence 2, il est nécessaire de calibrer périodiquement le générateur de fréquence 101. Le signal de calibration 4, issu d'une horloge atomique par exemple, génère par l'intermédiaire d'un circuit d'analyse CA, la commande de calibration 15. L'unité de commande enregistre en mémoire la valeur numérique qui devra être appliquée sur l'entrée de commande 7 du générateur d'horloge GH en cas de défaillance simultanée de tous les signaux de synchronisation externe. Des données numériques relatives au vieillissement du générateur de fréquence (dérive fréquentielle) seront avantageusement inscrites dans cette mémoire. La valeur de consigne prédédemment citée est ainsi déterminée.

La présente horloge synchronisée peut être doublée, notamment pour des raisons de fiabilité, comme cela a déjà été évoqué. Dans une telle configuration, un des signaux de contrôle 3 d'une première horloge synchronisée, est le signal d'horloge d'une deuxième horloge du même type. L'unité de commande UC de la première émet une alarme de défaut de fonctionnement 17 si, simultanément, tous les signaux de synchronisation externe 1,2 et le signal 3 issu de la deuxième horloge sont déclarés en défaut.

La représentation schématique des éléments de l'horloge synchromisée tels que représentés dans la figure a été adoptée pour la clarté de l'exposé. Il va sans dire que dans une réalisation pratique du dispositif on peut procéder autrement. Il est ainsi possible de regrouper différents circuits au sein d'un microprocesseur, c'est le cas par exemple de l'unité de commande UC et des filtres numériques 105. On peut également préferer une réalisation délocalisée où différents éléments seront physiquement présents sous la forme de différents composants.

## Revendications

1. Horloge synchronisée recevant plusieurs signaux de synchronisation externe qui sont soit un signal de référence (2) soit des signaux de rythme (1) et comprenant
- un générateur d'horloge (GH) recevant un signal de commande (12) et produisant un signal d'horloge (6),
- un dispositif d'asservissement (DA) recevant un desdits signaux de synchronisation externe (1,2) et ce signal d'horloge (6) qui élabore une commande d'asservissement (8),
- caractérisée en ce qu'elle comprend
- des moyens (DA,DR) pour élaborer une commande d'asservissement (8) additionnelle au moins associée à un autre desdits signaux de synchronisation externe (1,2),
- une unité de commande (UC) produisant ledit signal de commande (12) à partir d'une commande d'asservissement (8 ) sélectionnée et déterminant la commande d'asservissement sélectionnée en fonction de critères de qualité desdits signaux de synchronisation externe.

2. Horloge synchronisée selon la revendication précédente caractérisée en ce qu'elle comprend des moyens pour comparer une desdites commandes d'asservissement (8) à un gabarit spécifiant des valeurs extrêmales et des variations temporelles maximales afin de produire une information d'aspect de ladite commande d'asservissement, cette information d'aspect étant un desdits critères de qualité.

3. Horloge synchronisée selon l'une quelconque des revendications précédentes caractérisée en ce qu'elle comprend des circuits de test de présence de rythme (PR) recevant chacun un signal de synchronisation externe (1,2) et délivrant un signal de présence rythme (10) si le signal reçu est présent, l'existence de ce signal de présence rythme étant un desdits critères de qualité.

4. Horloge synchronisée selon l'une quelconque des revendications précédentes caractérisée en ce qu'elle reçoit des signaux de validation (5) associés chacun à un desdits signaux de rythme (1) signifiant un défaut sur ce signal de rythme, et en ce qu'elle élabore une information de validation associée à un desdits signaux de validation si celui-ci présente une durée inférieure à un seuil de durée et une fréquence d'apparition inférieure à un seuil de fréquence, la présence de cette information de validation étant un desdits critères de qualité.

5. Horloge synchronisée selon l'une quelconque des revendications précédentes caractérisée en ce que ladite unité de commande (UC) comprend une liste associant un rang de priorité à chacun desdits signaux desynchronisation externe (1,2), et en ce que ladite commande d'asservissement sélectionnée est la commande d'asservissement (8) correspondant au premier signal de synchronisation externe de cette liste répondant à au moins un desdits critères de qualité.

6. Horloge synchronisée selon l'une quelconque des revendications précédentes caractérisé en ce que la dite unité de commande (UC) a en mémoire une valeur de consigne, et sélectionne cette valeur de consigne comme ladite commande d'asservissement sélectionnée si aucun desdits signaux de synchronisation externe (1,2) ne répond à au moins un desdits critères de qualité.

7. Horloge synchronisée selon la revendication précédente caractérisé en ce qu'elle comprend un circuit d'analyse (CA) recevant un signal de calibration (4), ledit signal d'horloge (6) et produisant une commande de calibration (15), et en ce que ladite unité de commande (UC) comprend des moyens pour calculer ladite valeur de consigne à partir de cette commande de calibration.

8. Horloge synchronisée selon l'une quelconque des revendications précédentes caractérisée en ce qu'elle comprend au moins un circuit d'analyse (CA) recevant un signal de contrôle (3), ledit signal d'horloge (6) et produisant un signal de vérification (11) et en ce que ladite unité de commande (UC) produit une alarme (16) si ledit signal de vérification (11) n'est pas inscrit dans un gabarit spécifiant des valeurs extrêmales et des variations temporelles maximales.

9. Horloge synchronisée selon l'une quelconque des revendications précédentes caractérisée en ce qu'elle produit une alarme (13) si un desdits signaux de rythme (1) ne répond pas à au moins un desdits critères de qualité.

10. Horloge synchronisée selon l'une quelconque des revendications précédentes caractérisée en ce qu'elle produit une alarme (14) si ledit signal de référence (2) ne répond pas à au moins un desdits critères de qualité.

11. Horloge synchronisée selon l'une quelconque des revendications 8 à 10 caractérisée en ce qu'elle produit une alarme de fonctionnement (17) si un au moins desdits signaux de contrôle (3) n'est pas inscrit dans un gabarit spécifiant des valeurs extrêmales et des variations temporelles maximales et si aucun desdits signaux de synchronisation externe (1,2) ne répond à un au moins desdits critères de qualité.

12. Horloge synchronisée selon l'une quelconque des revendications précédentes caractérisée en ce que les fréquences desdits signaux de rythme (1) et/ou dudit signal de référence (2) et/ou desdits signaux de contrôle (3) et/ou dudit signal de calibration (4) sont des multiples de la fréquence dudit signal d'horloge (6).

## Patentansprüche

1. Synchronisierter Taktgeber, der mehrere äußere synchronisierte Signale empfängt, bei denen es sich entweder um ein Referenzsignal (2) oder um Taktsignale (1) handelt, und der aufweist:
- einen Taktgenerator (GH), der ein Steuersignal (12) empfängt und ein Taktsignal (6) erzeugt,
- eine Regeleinrichtung (DA), die eines der äußeren Synchronisationssignale(1,2) und das Taktsignal (6) empfängt und eine Regelungssteuerung (8) erzeugt,
dadurch gekennzeichnet, daß der Taktgeber aufweist:
- Mittel (DA, DR) zu Erzeugung einer zusätzlichen Regelungssteuerung (8), die mindestens einem anderen der äußeren Synchronisationssignale (1, 2) zugeordnet ist,
- eine Steuereinheit (UC), die das Steuersignal (12) aus einer gewählten Regelungssteuerung (8) erzeugt und die die gewählte Regelungssteuerung in Abhängigkeit von Qualitätskriterien der äußeren Synchronisationssignale bestimmt.

2. Synchronisierter Taktgeber nach Anspruch 1, dadurch gekennzeichnet, daß er Mittel zum Vergleichen einer der Regelungssteuerungen (8) mit einem Sollwertrahmen aufweist, der Extremwerte und maximale zeitliche Veränderungen spezifiziert, um eine Information zur Beurteilung der Regelungssteuerung zu erzeugen, wobei diese Beurteilungsinformation eines der Qualitätskriterien ist.

3. Synchronisierter Taktgeber nach Anspruch 1 oder 2, dadurch gekennzeichnet, daß er Testschaltungen (PR) für das Vorliegen des Takts aufweist, die je ein äußeres Synchronisationssignal (1, 2) empfangen und ein Taktpräsenzsignal (10) liefern, wenn das empfangene Signal vorhanden ist, wobei das Vorhandensein des Taktpräsenzsignals eines der Qualitätskriterien ist.

4. Synchronisierter Taktgeber nach einem beliebigen der vorhergehenden Ansprüche, dadurch gekennzeichnet, daß er Freigabesignale (5) empfängt, die je einem der Taktsignale (1) zugeordnet sind und einen Ausfall dieses Taktsignals anzeigen, und daß er eine Freigabeinformation erzeugt, die einem der Freigabesignale zugeordnet ist, falls dieses eine Dauer unter einer Schwelle besitzt, und mit einer Frequenz auftritt, die kleiner als eine Frequenzschwelle ist, wobei das Vorhandensein dieser Freigabeinformation eines der Qualitätskriterien ist.

5. Synchronisierter Taktgeber nach einem beliebigen der vorhergehenden Ansprüche, dadurch gekennzeichnet, daß die Steuereinheit (UC) eine Liste enthält, die jedem der äußeren Synchronisationssignale (1, 2) einen Prioritätsrang zuordnet, und daß die gewählte Regelungssteuerung die dem ersten äußeren Synchronisationssignal der Liste entsprechende Regelungssteuerung (8) ist, die mindestens einem der Qualitätskriterien entspricht.

6. Synchronisierter Taktgeber nach einem beliebigen der vorhergehenden Ansprüche, dadurch gekennzeichnet, daß die Steuereinheit (UC) einen Sollwert gespeichert hat und diesen Sollwert als die gewählte Regelungssteuerung wählt, wenn keines der äußeren Synchronisationssignale (1, 2) zumindest einem der Qualitätskriterien entspricht.

7. Synchronisierter Taktgeber nach einem beliebigen der vorhergehenden Ansprüche, dadurch gekennzeichnet, daß er eine Analyseschaltung (CA) aufweist, die ein Eichsignal (4) und das Taktsignal (6) empfängt und eine Eichsteuerung (15) erzeugt, und daß die Steuereinheit (UC) Einrichtungen zum Berechnen des Sollwertes aus der Eichsteuerung aufweist.

8. Synchronisierter Taktgeber nach einem beliebigen der vorhergehenden Ansprüche, dadurch gekennzeichnet, daß er mindestens eine Analyseschaltung (CA) aufweist, die ein Steuersignal (3) und das Taktsignal (6) empfängt und ein Überprüfungssignal (11) erzeugt, und daß die Steuereinheit (UC) einen Alarm (16) erzeugt, wenn daß Überprüfungssignal (11) nicht in einem Sollwertrahmen paßt, der Extremwerte und maximale zeitliche Änderungen spezifiziert.

9. Synchronisierter Taktgeber nach einem beliebigen der vorhergehenden Ansprüche, dadurch gekennzeichnet, daß er einen Alarm (13) erzeugt, wenn eines der Taktsignale (1) nicht mindestens einem der Qualitätssignale entspricht.

10. Synchronisierter Taktgeber nach einem beliebigen der vorhergehenden Ansprüche, dadurch gekennzeichnet, daß er einen Alarm (14) erzeugt, wenn das Referenzsignal (2) nicht zumindest einem der Qualitätskriterien entspricht.

11. Synchronisierter Taktgeber nach einem beliebigen der Ansprüche 8 bis 10, dadurch gekennzeichnet, daß er einen Betriebsalarm (17) erzeugt, wenn mindestens eines der Kontrollsignale (3) nicht in einen Sollwertrahmen paßt, der Extremwerte und maximale zeitliche Änderungen spezifiziert, und wenn keines der äußeren Synchronisationssignale (1, 2) wenigstens einem der Qualitätskriterien entspricht.

12. Synchronisierter Taktgeber nach einem beliebigen der vorhergehenden Ansprüche, dadurch gekennzeichnet, daß die Frequenzen der Taktsignale (1) und/oder des Referenzsignals (2) und/oder der Kontrollsignale (3) und/oder des Eichsignals (4) Vielfache der Frequenz des Taktsignals (6) sind.

## Claims

1. A synchronized clock receiving a plurality of external synchronization signals, which external signals may be constituted either by a reference signal (2) or by rate signals (1), the clock comprising:
a clock generator (GH) receiving a control signal (12) and producing a clock signal (6);
a servo-control circuit (DA) receiving said clock signal (6) and a corresponding one of said external synchronization signals (1, 2), and generating a servo-control signal (8);
the clock being characterized in that it further comprises:
means (DA, DR) for generating an additional servo-control signal (8) associated at least with one other one of said external synchronization signals (1, 2); and
a control unit (UC) producing said control signal (12) on the basis of a selected servo-control signal (8); and
determining which servo-control signal to select as a function of quality criteria for said external synchronization signals.

2. A synchronized clock according to the preceding claim, characterized in that it includes means for comparing one of said servo-control signals (8) with an acceptance range specifying extreme variations and maximum time values and producing an aspect flag relating to said servo-control signal, said aspect flag constituting one of said quality criteria.

3. A synchronized clock according to any preceding claim, characterized in that it includes rate presence test circuits (PR) each receiving a corresponding one of the external synchronization signals (1, 2) and delivering a rate-present signal (10) if the received signal is present, the existence of said rate-present signal constituting one of said quality criteria.

4. A synchronized clock according to any preceding claim, characterized in that it receives enable signals (5) associated with respective ones of said rate signals (1) and indicative of a fault on the corresponding rate signal, and in that it generates an enable flag associated with each of said enable signals providing the duration thereof is less than a duration threshold and the frequency of appearance thereof is less than a frequency threshold, with the presence of said enable flag constituting one of said quality criteria.

5. A synchronized clock according to any preceding claim, characterized in that said control unit (UC) includes a list associating a priority order with each of said external synchronization signals (1, 2), and in that said selected servo-control signal is that one of the servo-control signals (8) which corresponds to the highest priority external synchronization signal in said list that satisfies at least one of said quality criteria.

6. A synchronized clock according to any preceding claim, characterized in that the said control unit (UC) has a reference value in its memory, and selects said reference value as said selected servo-control signal in the event that none of said external synchronization signals (1, 2) satisfies at least one of said quality criteria.

7. A synchronized clock according to the preceding claim, characterized in that it includes an analysis circuit (CA) receiving both said clock signal (6) and a calibration signal (4), and producing a calibration control signal (15), and in that said control unit (UC) includes means for calculating said reference value on the basis of said calibration control signal.

8. A synchronized clock according to any preceding claim, characterized in that it includes at least one analysis circuit (CA) receiving both said clock signal (6) and a monitor signal (3), and producing a verification signal (11), and in that said control unit (UC) produces an alarm signal (16) if said verification signal (11) does not lie within an acceptance range specifying extreme values and maximum time variations.

9. A synchronized clock according to any preceding claim, characterized in that it produces an alarm signal (13) if any one of said rate signals (1) does not satisfy at least one of said quality criteria.

10. A synchronized clock according to any preceding claim, characterized in that it produces an alarm signal (14) if said reference signal (2) does not satisfy at least one of said quality criteria.

11. A synchronized clock according to any one of claims 8 to 10, characterized in that it produces an operating alarm signal (17) if at least one of said monitor signals (3) does not lie within an acceptance range specifying extreme values and maximum time variations, and if none of said external synchronization signals (1, 2) satisfies at least one of said quality criteria.

12. A synchronized clock according to any preceding claim, characterized in that the frequencies of said rate signals (1) and/or of said reference signal (2) and/or of said monitor signals (3) and/or of said calibration signal (4) are multiples of the frequency of said clock signal (6).
